## Europäisches Patentamt

## European Patent Office

## Office européen des brevets

(11) Veröffentlichungsnummer: **0 129 662**
**B1**

(12) # EUROPÄISCHE PATENTSCHRIFT

(45) Veröffentlichungstag der Patentschrift: **04.07.90**

(51) Int. Cl.⁵: **G 12 B 11/00**, G 01 D 13/00

(21) Anmeldenummer: **84104379.7**

(22) Anmeldetag: **18.04.84**

(54) **Leuchtbandanzeigeanordnung.**

(30) Priorität: **17.05.83 DE 3317807**

(43) Veröffentlichungstag der Anmeldung:
**02.01.85 Patentblatt 85/01**

(45) Bekanntmachung des Hinweises auf die
Patenterteilung:
**04.07.90 Patentblatt 90/27**

(84) Benannte Vertragsstaaten:
**AT BE CH FR GB IT LI NL SE**

(56) Entgegenhaltungen:
CH-A- 377 462
DE-U-7 715 970
DE-U-7 834 882
FR-A-2 473 202
FR-A-2 514 527

(73) Patentinhaber: **Preh-Werke GmbH & Co. KG**
**Postfach 1740 An der Stadthalle**
**D-8740 Bad Neustadt/Saale (DE)**

(72) Erfinder: **Bauer, Karl-Heinz**
**Lerchenstrasse 9**
**D-8740 Bad Neustadt/Saale (DE)**
Erfinder: **Wolf, Reinhold**
**Hangweg 17**
**D-8740 Bad Neustadt/Saale (DE)**

**Beschreibung**

Die Erfindung geht von einer Leuchtbandanzeigeanordnung zur thermometerskalaähnlichen Anzeige der Stellung eines Betätigungsorganes nach dem Oberbegriff des Anspruches 1 aus.

Leuchtbandanzeigeanordnungen werden neben numerischen und alphanumerischen Anzeigeeinheiten in den verschiedensten Ausführungsformen in nahezu allen Bereichen der Elektrotechnik und Elektronik als Analoganzeige verwendet. So dient z.B. in der Meßtechnik zur Anzeige einer Meßspannung ein Leuchtband, dessen Länge der Meßspannung proportional ist und das aus zahlreichen aneinandergereihten Leuchtsegmenten besteht, die über zugehörige elektronische Schalter mit einer Erregerspannung verbunden sind.

Aus der DE—B 24 42 876 ist bereits eine derartige Schaltungsanordnung für eine thermometerskalaähnlichen Anzeige bekannt. Diese Schaltungsanordnung besteht aus mehreren gleichsinnig in Reihe geschalteten Leuchtdioden, die von einer Konstantstromquelle gespeist werden. Die Leuchtdioden werden hierbei von einem parallel angeordneten Schalttransistor angesteuert. Die Emitter aller Schalttransistoren besitzen eine gemeinsame Verbindung, die mit der Kathode der letzten Leuchtdiode auf gleichem Potential liegt, welches durch eine Spannungsfolgerschaltung veränderbar ist. Die Basisleerlaufspannung jedes Schalttransistors ist durch zwei als Spannungsteiler geschaltete Widerstände festgelegt, wobei sich die Basisleelaufspannungen stufenweise um einen kleinen Betrag unterscheiden. Bei dieser Anzeige wird für jedes Leuchtsegment eine eigene Leuchtdiode benötigt.

Nur eine einzige Lichtquelle wird bei der aus der DE—B 16 90 329 bekannten Beleuchtungseinrichtung für ein Drucktastenaggregat benötigt. Es ist ein von dieser Lichtquelle aus zu den einzelnen Schaltern geführter Lichtleiterblock vorhanden, der auf der Schalterseite plan ist und der auf der gegenüberliegenden Seite mit Reflektorflächen versehen ist, die die Lichtstrahlen auf die plane Seite werfen. Die Reflektorflächen werden mit zunehmendem Abstand von der Lichtquelle größer und sie sind gegeneinander versetzt angeordnet. Ist eine Drucktaste gedrückt, so gelangt ein mit dieser bewegbarer Lichtleiter in unmittelbare Nähe der planen Seite und die Lichtstrahlen gelangen vom Lichtleiterblock zur Drucktaste, von der eine bestimmte Fläche beleuchtet wird.

Ein Schaltstellungsanzeige für Elektroherde ist bereits aus der DE—B 12 52 782 bekannt (siehe auch CH—A—377 462). Von einer mit einem Reflektor auf einer Seite abgeschirmten Lichtquelle gelangen Lichtstrahlen zu mehreren Lichtleitern. Die Lichtaustrittsstellen sind als Anzeigeskala aneinandergereiht und in drei parallelen Reihen übereinander angeordnet. Auf einer durch einen Drehgriff drehbaren Welle sind Blendenscheiben mit der Welle verdrehungssteif befestigt, die die Lichteintrittsstellen gegen die Lichtquelle abschirmen.

In der DE—A 31 09 868 ist ein Drucktastenaggregat beschrieben, das mehrere mittels einer Sperrschiene sich gegenseitig auslösende Drucktasten aufweist. Ferner ist eine Leuchtanzeigeeinrichtung für jede der gedrückten Drucktasten vorhanden. Diese besteht aus einem Leuchtzentrum mit einer in einem Hohlraum angeordneten Lichtquelle, von dem mehrere Lichtleiter sternförmig weggeführt sind. Jeweils eines der Enden der Lichtleiter leuchtet auf, wenn eine der zugehörigen Drucktasten gedrückt ist. Ist die Drucktaste nicht gedrückt, so schiebt sich ein Teil der Drucktasten in den Lichtleiter und unterbricht damit die Lichtstrahlen, so daß das Ende des Lichtleiters dunkel erscheint. Reiht man mehrere Drucktastenaggregate aneinander, so können von dem gleichen Leuchtzentrum aus auch die Lichtleiter in mehreren Ebenen geführt sein. Die Enden der Lichtleiter sind dann entsprechend den Drucktastenreihen auch in mehreren Reihen nebeneinander angeordnet.

Aus dem DE—U 78 34 882 ist ein einstellbarer Drehwiderstand bekannt, bei dem die Stellung des Schleifers des Federträgers durch eine Leuchtanzeigeeinrichtung dargestellt werden kann. Diese Leuchtanzeigeeinrichtung besteht aus einem Leuchtzentrum mit einer in ihrem Hohlraum angeordneten Lichtquelle, wobei vom Leuchtzentrum aus sternförmig Lichtleiter weggeführt sind, deren Enden in einer Reihe nebeneinander liegend eine Anzeigeskala darstellen. Durch den Hohlraum wird eine Art Fassung gebildet. Zwischen der Wand der Fassung und der Lichtquelle ist ein hohlzylinderförmiges Drehteil angeordnet, das in seiner Wand eine Ausnehmung aufweist, die in ihrer Abmessung etwa einer Lichteintrittsstelle entspricht. Das Drehteil besteht aus einem lichtundurchlässigen Werkstoff, während die Ausnehmung als Lichtaustrittsstelle wirkt. In die Ausnehmung kann eine Abdeckung eingesetzt sein, die ein- oder mehrfarbig ausgebildet ist. Das Licht kann nur da zum Lichtleiter gelangen, wo sich gerade die Ausnehmung befindet. Es ist somit nur eine Punktanzeige möglich, bei der in Abhängigkeit von der Stellung des Schleifers ein Leuchtpunkt entlang der Anzeigeskala wandern kann.

Aufgabe der vorliegenden Erfindung ist es, eine Leuchtbandanzeigeanordnung zu schaffen, bei der in einer der Anschlagstellungen des Betätigungsorganes alle Leuchtsegmente der ganzen Anzeigeskala in einer Farbe leuchten.

Diese Aufgabe wird erfindungsgemäß durch die im Kennzeichnungsteil des Anspruches 1 angegebenen Merkmale gelöst.

Vorteilhafte Ausgestaltungen ergeben sich aus den Abhängigen Ansprüchen.

Würde man die Farbbänder nur jeweils solange machen, daß sie den halben Umfang des Abdeckkörpers bedecken, ohne sich zu überlappen, so könnte jeweils—da z.B. der gesamte Drehbereich weniger als 360° beträgt—nur etwa über die Hälfte des Drehbereiches mit einer Farbe bedeckt werden. Für den Schiebebereich gilt Ähnliches. Durch die erfindungsgemäße Ausgestaltung der Anordnung mit den verlängerten, herausgeführten Farbbändern ist est so möglich, jeweils den ganzen Schiebe—oder Drehbereich mit nur einer Farbe anzeigen zu können. Demzufolge leuchten an einem Anschlag die Leuchtsegmente z.B. nur in der Farbe rot, während sie am anderen Anschlag z.B. nur in der Farbe blau erscheinen.

Die Erfindung wird nachfolgend für mehrere Ausführungsbeispiele anhand der Zeichnungen näher beschrieben.

Von den Figuren zeigt

Figur 1 eine auseinandergezogene, perspektivische Ansicht einer Leuchtbandanzeigeanordnung mit einem Drehknopf,

Figur 2 eine Seitenansicht der Leuchtbandanzeigeanordnung im Schnitt,

Figur 3 eine Vorderansicht der Leuchtbandanzeigeanordnung,

Figur 4 eine Vorderansicht der Frontplatte ohne Drehknopf, jedoch mit der rückwärtigen Zahnstange und dem Führungssteg,

Figur 5 einen Schnitt durch das Leuchtzentrum mit einem Farbband,

Figur 6 einen Schnitt durch das Leuchtzentrum mit zwei Farbbändern,

Figur 7 eine Seitenansicht einer weiteren Leuchtbandanzeigeanordnung im Schnitt mit einem direkt angekoppelten einstellbaren Widerstand,

Figur 8 eine auseinanderbezogene, perspektivische Ansicht einer anderen Leuchtbandanzeigeanordnung mit einem Schieber,

Figur 9 in Perspektivansicht im vergrößerten Maßstab einen Teilausschnitt der Führungsschiene mit Schieber,

Figur 10 in Seitenansicht einen Schnitt durch die Anordnung,

Figur 11 in Perspektivansicht im vergrößerten Maßstab teilweise aufgebrochen einen Teilausschnitt eines Schiebers mit Brems- und Rastorgan.

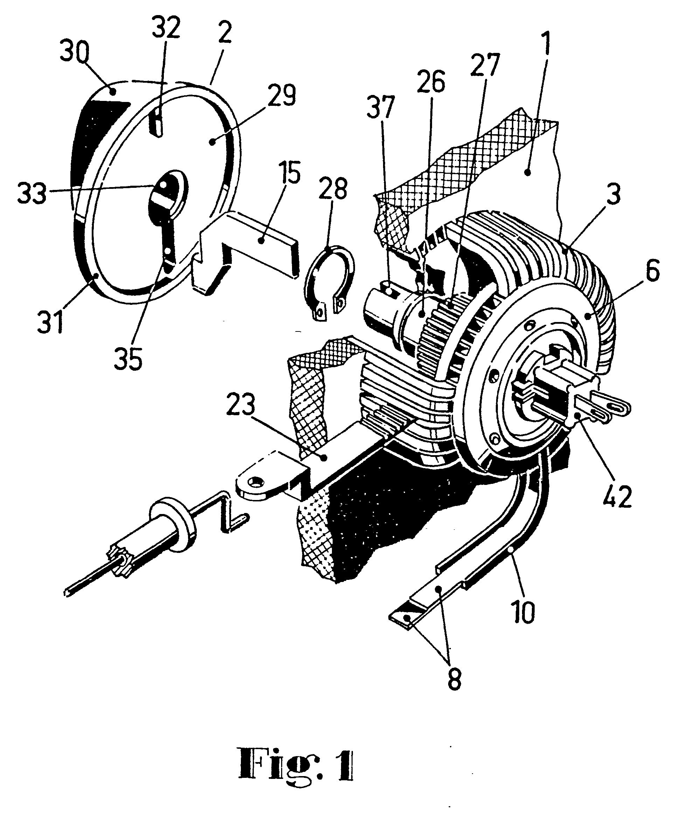

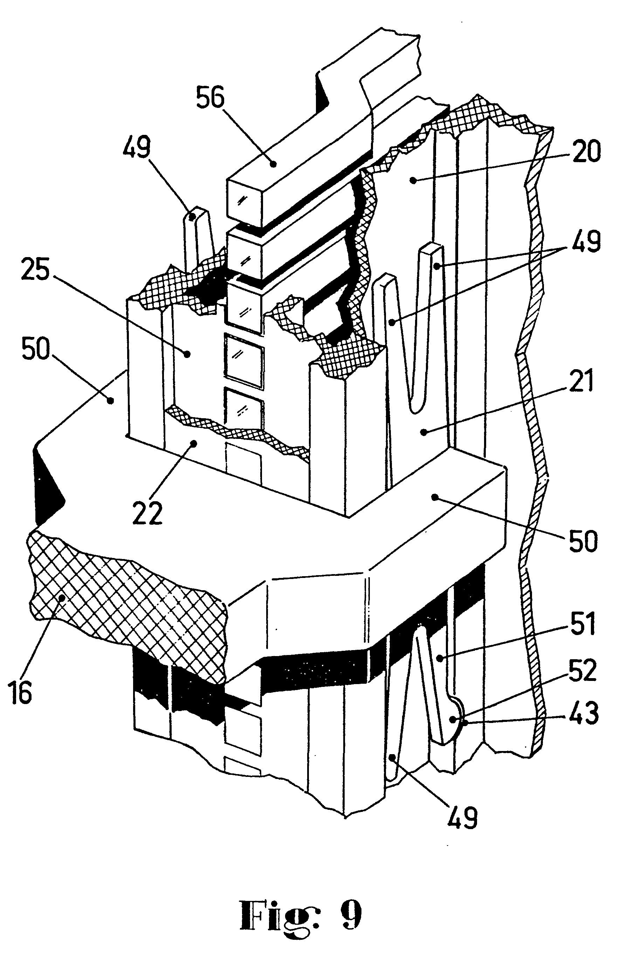

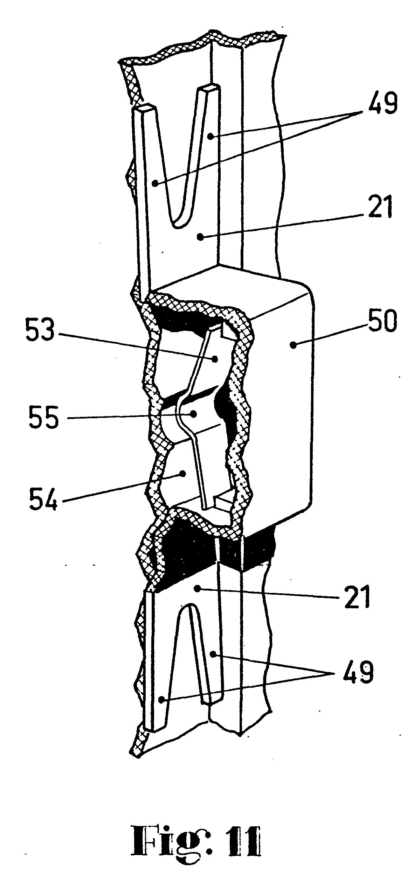

In den Figuren sind im wesentlichen zwei Ausführungsformen einer Leuchtbandanzeigeanordnung dargestellt. Bei den Figuren 1 bis 7 wurde eine kreisförmige Anordung der Leuchtsegmente 4, die von den Enden der Lichtleiter 3 gebildet werden, gewählt. Die Figuren 8 bis 11 zeigen eine geradlinige Anordnung. Sowohl die kreisförmige als auch die geradlinige Leuchtbandanzeige sind Teil einer Einstelleinrichtung, wie sie z.B. in Kraftfahrzeugen zur Anzeige des Heizungs- und des Lüftungssystems eingesetzt werden können. Diese Einstelleinrichtunge verfügen entweder -im Falle der kreisförmigen Anordnung der Leuchtsegmente- über einen Drehknopf 2 oder- im Falle der geradlinigen Anordnung- über einen Schieber 16 zur meist mittelbaren Betätigung von Verstellelementen. Bei den Verstellelementen kann es sich um mechanische oder elektrische Bauelemente, wie z.B. Klappen oder Motoren, handeln. Während die mittelbare mechanische Betätigung über Zahnstangen, Zahnräder, Seiltriebe, Bowdenzüge usw. erfolgt, setzt man bei der mittelbaren elektrischen Betätigung z.B. Potentiometer oder Schalter ein, die durch den Drehknopf oder den Schieber betätigt werden, wobei deren Stellung mit Hilfe der abgegriffenen Spannung auf das elektrische Verstellelement übertragen wird. Demzufolge gibt es eine ganze Reihe von Ausführungsformen für die nachfolgend anhand im wesentlichen zweier Beispiele dargestellten Leuchtbandanzeigeanordnung.

Figur 1 zeigt in perspektivischer Darstellung die Anwendung einer kreisförmigen Anordnung der Leuchtsegmente. Mit 1 ist dort eine Frontplatte aus Kunststoff bezeichnet, die Teil eines größeren Gerätes oder einer größeren Anordnung ist. In der Frontplatte befindet sich eine kreisförmige Öffnung, in die eine hohlzylinderförmige Welle 26 drehbar gelagert ist. Diese Welle 26 besitzt ein im Durchmesser etwas vergrößertes Zahnrad 27, dessen gegenüber der Welle überstehender Teil als Anschlag an der Frontplatte 1 dient. Auf der Außenseite der Frontplatte ist die Welle 26 durch einen Sprengring 28 oder durch nicht dargestellte mitangeformte Schnapphaken gegen eine axiale Verschiebung gesichert.

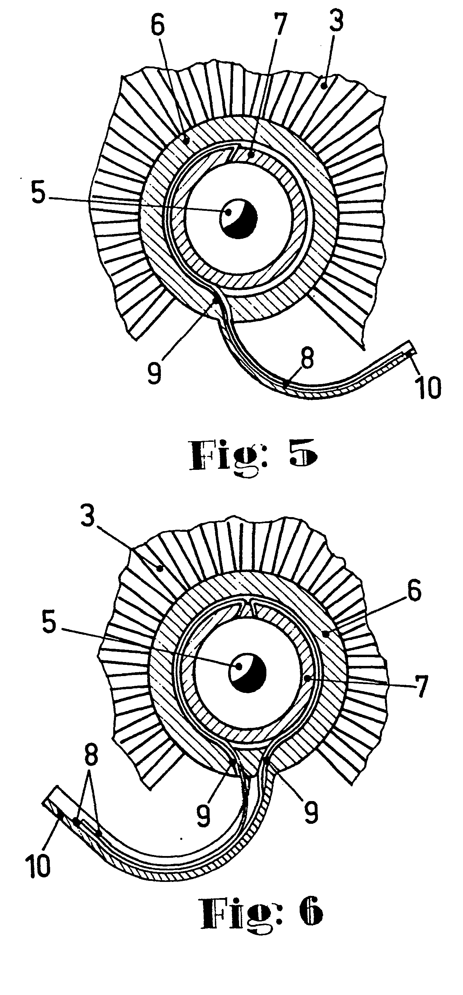

Der Drehknopf 2 besteht aus einem scheibenförmigen Basisteil 29, an das ein Griffstück 30 angeformt ist. Das Basisteil 29 besitzt einen umfangseitig verlaufenden, etwas erhöhten Rand 31. Von diesem Rand radial nach innen verläuft ein kurzer stegartiger Vorsprung 32, der mit zwei vorstehenden Nasen 36 der Frontplatte im Sinne einer Drehbereichsbegrenzung zusammenwirkt. Diese Nasen 36 befinden sich, wie aus Figur 4 erkennbar ist, etwa auf dem gleichen Radius wie der Vorsprung, jedoch am Umfang versetzt zueinander entsprechend dem gewünschten Drehbereich.

In der Mitte des Basisteils 29 des Drehknopfes 2 ist eine Höhlung 33 ausgespart, die sich in das Griffstück 30 fortsetzt und die auf der Frontseite des Griffstücks durch ein Fenster 34 aus einem durchsichtigen Material abgeschlossen ist. Das Fenster kann mit Anzeigesymbolen versehen sein. Von der Höhlung 33 aus erstreckt sich radial im Basisteil und im Griffstück ein Schlitz 35, der endseitig in der Nähe des Randes durch einen Durchbruch zur Frontseite des Griffstückes fortgesetzt ist. In die Höhlung 33, den Schlitz 35 und den Durchbruch ist ein Einsatz 15 eingeführt, der aus einem lichtleitenden Material hergestellt ist. Wie aus Figur 1 zu entnehmen ist, ist dieser Einsatz 15 mehrfach abgewinkelt und mit Abschrägungen zur Umlenkung der Lichtstrahen versehen. Durch das im Fenster 34 und im Durchbruch sichtbare Licht wird zum einen der Drehknopf selbst und zum anderen die Drehstellung auch im Dunkeln sichtbar gemacht.

Die Mitnahme der Welle 26 durch den Drehknopf 2 erfolgt derart, daß die Welle stirnseitig zweit sich diametral gegenüberliegende Einschnitte 37 besitzt, wobei auf der einen Seite der Einsatz 15 in einen der Einschnitte eintaucht und wobei auf der gegenüberliegenden Seite eine in die Höhlung 33 ragende, angeformte und in den Figuren nicht sichtbare Erhebung in den anderen Einschnitt hineinragt. Zur Befestigung des Drehknopfes an der Welle kann man die Erhebung und den Einschnitt so ausbilden, daß ein Schiebesitz mit Snap-in-Effekt entsteht.

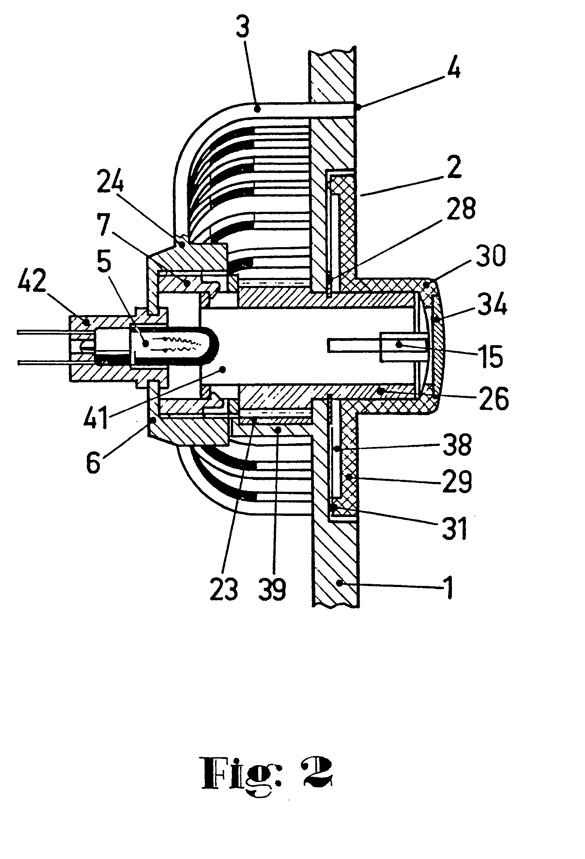

Wie aus den Figuren 2 und 4 erkennbar ist, ist in der Frontplatte 1 auf der Außenseite eine kreisförmige Mulde 38 ausgespart, deren Durchmesser geringfügig größer ist als der Durchmesser des Basisteils 29 des Drehknopfes 2. In dieser Mulde befinden sich, wie Figur 4 zeigt, am Boden die bereits erwähnten Nasen 36 und der Sprengring 28. Mit dem Rand 31 gleitet der Drehknopf am Boden der Mulde 38. Die Tiefe der Mulde und die Höhe des Randes 31 sind dabei so gewählt, daß die Oberseite des Basisteils des Drehknopfes etwa mit der Oberfläche der Frontplatte auf einer Höhe liegt.

In unmittelbarer Nähe der Lageröffnung der Welle in der Frontplatte befindet sich auf deren Rückseite eine angeformte Führungsleiste 39 mit einer durchgehenden Führungskammer zur Aufnahme einer darin verschiebbaren Zahnstange 23. Die Führungsleiste ist in Figur 4 mit gestrichelten Linien dargestellt, da sie auf der Rückseite der Frontplatte angeordnet ist. Auf einer Seite ist die Zahnstange über einen bestimmten Bereich ihrer Länge mit Zähnen 40 versehen, die durch einen Ausschnitt in der Führungskammer hindurch mit den Zähnen des Zahnrades 27 in Eingriff stehen. Wird die Welle gedreht, so verschiebt sich die Zahnstange und über einen Seil- oder Bowdenzug können Verstellelemente oder auch Schiebepotentiometer oder Schiebeschalter betätigt werden, die ihrerseits wieder auf elektrischem Wege meist elektrische Verstellelemente in Bewegung setzen.

An der Welle 26, die aus einem glasfaserverstärktem Material besteht, ist mit ihr drehbar ein Abdeckkörper 7 befestigt, der aus einem glasklaren Material hergestellt ist. Der Abdeckkörper kann an die Welle, mit der er schlupffrei verbunden ist, geklebt, aufgesteckt oder mit ihr durch eine Snap-in-Verbindung verbunden sein. Der Abdeckkörper 7 ist topfförmig ausgebildet und besitzt am Boden einen Durchbruch 41, so daß das von einer Lichtquelle 5 erzeugte Licht durch den Durchbruch hindurch zu dem Einsatz 15 des Drehknopfes 2 gelangen kann. Falls eine farbige Anzeige des Drehknopfes gewünscht ist, kann das Fenster 34 und/oder der Einsatz eingefärbt sein. Auch ist es möglich eine farbige Zwischenscheibe zwischen Lichtquelle und Einsatz einzusetzen. Es ist auch denkbar, Welle und Abdeckkörper einteilig aus einem durchsichtigen, harten Kunststoff herzustellen. Welle und Abdeckkörper sind dann rohrförmig ausgebildet.

In den Abdeckkörper 7 ragt eine Lichtquelle 5, die an einem Fassungskörper 6 mit Hilfe einer Lampenfassung 42 befestigt ist. Der Fassungskörper ist ebenfalls topfförmig ausgebildet, wobei der Abdeckkörper in den Fassungskörper hineinragt. Der Fassungskörper ist aus mehreren Teilen zusammengesetzt, wobei die Teile, die kein Licht leiten sollen, aus einem lichtundurchlässigen Material bestehen. Mit Hilfe zweier in den Figuren nicht sichtbarer Zapen ist der Fassungskörper an der Rückwand der Frontplatte befestigt. In Figur 4 sind lediglich die beiden Befestigungsschrauben zu erkennen. Abdeckkörper 7 und Fassungskörper 6 bilden zusammen ein Leuchtzentrum, von dem aus die Lichtleiter 3 geführt sind. Bei dem Ausführungbeispiel nach Figur 2 sind die Lichtleiter in einer Ebene angeordnet. In mehreren Ebenen sind die Lichtleiter in dem Ausführungsbeispiel nach Figur 7 geführt. Eine dritte Ebene ist dort mit gestrichelten Linien angedeutet.

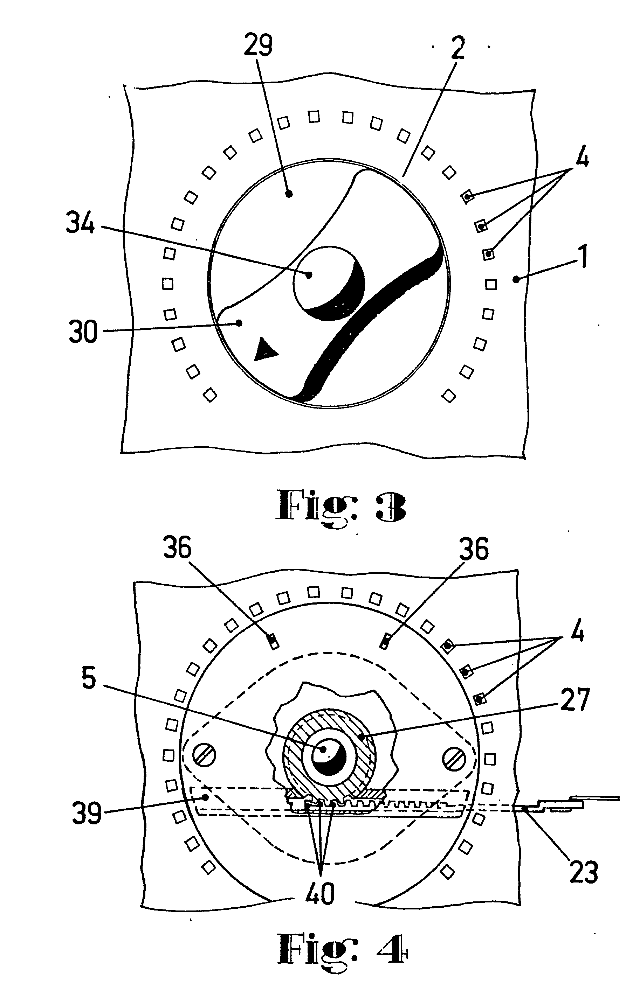

Jeder Lichtleiter 3 besitzt eine Lichtleiterlichteintrittsstelle 24 und ein Leuchtsegment 4, das das Ende des Lichtleiters darstellt. Die Leuchtsegmente sind, wie aus den Figuren 3 und 4 entnehmbar ist, kreisförmig in einem relativ großen Abstand in der Frontplatte angeordnet, jedoch nur so, daß ein Dreiviertel des Kreises davon bedeckt ist. Wünscht man eine dichtere nebeneinanderliegende Anordnung der Leuchtsegmente, so müssen Lichtleiter in mehreren Ebenen verwendet werden, wobei sie am Ende zusammengeführt sind.

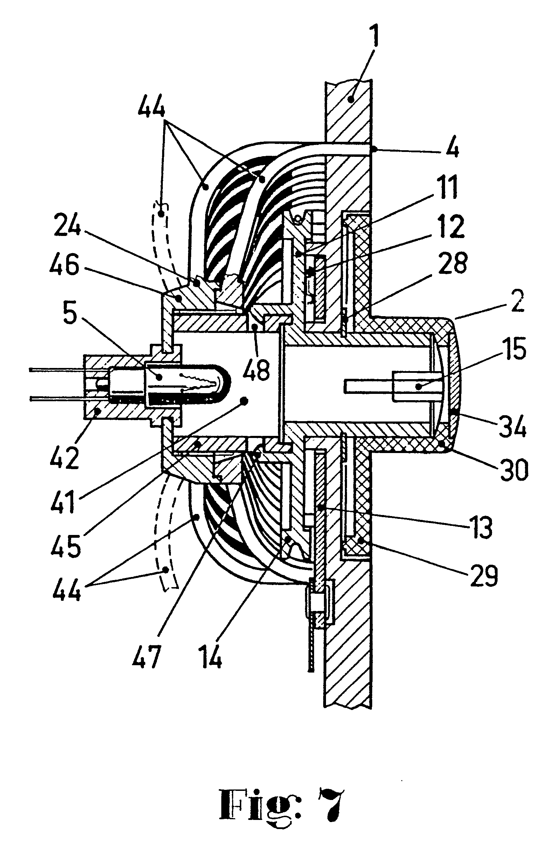

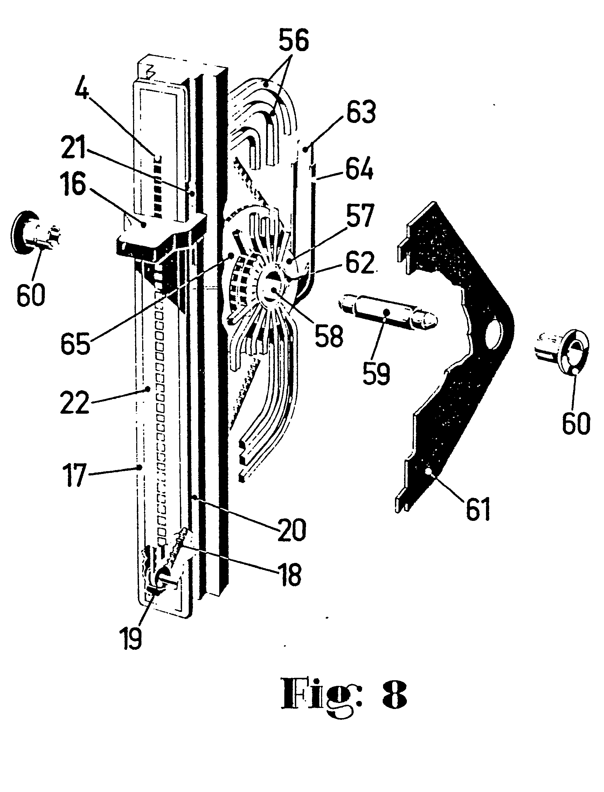

Am Abdeckkörper sind, wie aus den Figuren 5 und 6 hervorgeht, Farbbänder 8 befestigt. Figur 5 zeigt ein Ausführungsbeispiel mit nur einem Farbband, während in Figur 6 ein Beispiel mit zwei Farbbändern dargestellt ist. Ist nur ein Farbband vorhanden, so leuchtet ein Teil der Leuchtsegmente—entsprechend der Stellung des Drehknopfes—in der Farbe des Farbbandes, während die restlichen Leuchtsegmente in der Farbe des Kunststoffes, z.B. in weißer Farbe, oder in dem dem Spektrum der Lichtquelle entsprechenden Licht aufleuchten. Sind zwei Farbbänder vorhanden, z.B. mit roter und blauer Einfärbung, so leuchtet ein Teil der Leuchtsegmente rot und der andere Teil blau. Damit ist leicht zu erkennen, wie z.B. im Kraftfahrzeug die Heizung und die Lüftung eingestellt sind. Da in den Endanschlagstellungen alle Leuchtsegmente in einer Farbe leuchten sollen, muß jedes Farbband länger als der Umfang eines Halbkreises sein, da die Lichtleiter sich nahezu über ein Dreiviertel des Kreisumfanges erstrecken.

Un auch längere Farbbänder benutzen zu können, weist der Fassungskörper 6 eine oder mehrere Austrittsöffnungen 9 auf, aus denen das Farbband aus dem Fassungskörper heraustreten kann. Damit die Farbbänder nicht beschädigt werden, ist eine bogenförmige Führung 10 vorgesehen, die z.ß. an den Fassungskörper angeformt sein kann. In dieser Führung sind die Farbbänder geführt.

In Figur 7 ist ein weiteres Ausführungsbeispiel dargestellt. Hier ist mit dem Drehknopf 2 ein Federträger 11 gekuppelt, der eine Schleiffeder 12 trägt. Diese aus Metall hergestellte Schleiffeder stellt eine gute elektrisch leitende Verbindung zwischen einer Widerstandsbahn und einer Kollektorbahn eines Potentiometers her, die beide auf eine Widerstandsplatte 13 aus z.B. Hartpapier nach einem der bekannten Verfahren aufgebracht sind. Die entsprechenden Lötanschlüsse sind unten an der Widerstandsplatte angebracht. Die je nach Stellung des Drehknopfes abgreifbare Spannung kann direkt zur Einstellung eines Verstellelementes verwendet werden. Gleichzeitig mit dargestellt in Figur 7 ist eine weitere Ausführungsform, bei der über eine anstelle des Federträgers 11 verwendete Seilscheibe 14 mittels eines Seiltriebes ein Verstellelement mechanisch oder über ein entfernt befindliches Potentiometer elektrisch eingestellt werden kann.

Im Gegensatz zu dem vorher beschriebenen Ausführungsbeispiel sind die Lichtleiter 44 hier in zwei- oder mit gestrichelten Linien dargestellt in drei- Ebenen geführt. Die Enden aller Lichtleiter sind zusammengeführt und bilden mit ihren Leuchtsegmenten eine kreisförmige, einreihige Anordnung.

An der Seilscheibe sind zwei diametral gegenüberliegende Schnapphaken 47 vorgesehen, die in Aussparungen 48 des Abdeckkörpers rastend eingreifen. Ansonsten entspricht der übrige Aufbau dem in den Figuren 1 bis 6 beschriebenen Ausführungsbeispiel.

Während in den Ausführungsbeispielen gemäß den Figuren 1 bis 7 die Leuchtsegmente kreisförmig angeordnet sind, liegen sie bei den in den Figuren 8 bis 11 dargestellten Ausführungsbeispielen geradlinig hintereinander. Auf einer länglichen Führungsschiene 17 ist ein Schieber 16 geführt. Die zwischen den Schieberarmen 50 liegende Frontseite der Führungsschiene 17 weist eine Vertiefung 25 auf, in der sich eine lichtdurchlässige Deckplatte 22 befindet. Die Stärke der Deckplatte und die Tiefe der Vertiefung sind zweckmäßigerweise so gewählt, daß deren Oberflächen fluchtend liegen.

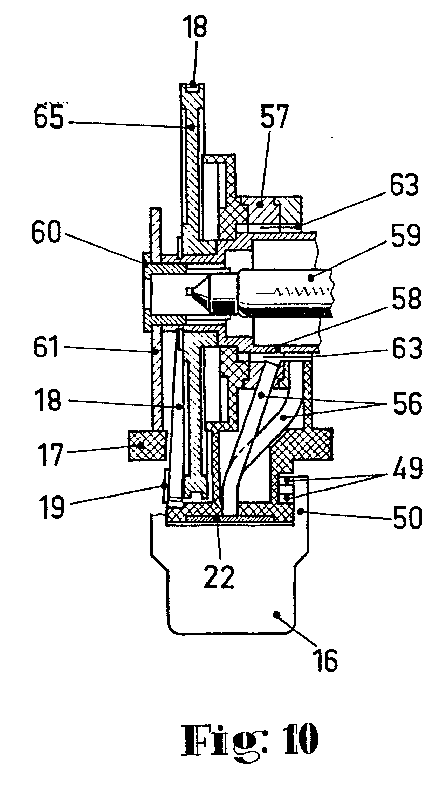

In den Seitenwandungen der Frontseite sind zwei sich in Schieberichtung erstreckende Längsausnehmungen 20 vorgesehen. Wie aus Figur 9 entnommen werden kann, sind in den Längsausnehmungen 20 stegartige Gleitkörper 21 geführt, die an die Schieberarme 50 angeformt sind. Diese Gleitkörper besitzen Spreizarme 49, die nach außen federnd einen guten Schiebegang des Schiebers gewährleisten sollen. In manchen Fällen ist es wünschenswert, die Mittelstellung des Schiebers durch eine Rast festzulegen. Zu diesem Zweck kann einer der beiden oder auch beide Spreizarme als Federzunge 51 mit einem balligen freien Ende 52 ausgebildet sein, das mit einer Einbuchtung 43 in der Führungschiene im Sinne einer Rastung zusammenwirkt. Eine entsprechende Ausführung ist in Figur 9 unten dargestellt. Ist das Ende der Federzunge außerhalb der Einbuchtung, so wirkt die Federzunge als zusätzliches Bremsorgan für den Schieber.

Anstelle einer derartigen angeformten Federzunge kann man auch eine eigene Bremsfeder 53 aus Metall in den Schieberarm einsetzen. Hierzu ist im Schieberarm eine Kammer 54 vorgesehen, in die, wie in Figur 11 dargestellt, die Bremsfeder 53 eingesetzt ist. Die Bremsfeder besitzt etwa mittig eine Auswölbung 55, die mit einer Einbuchtung am Boden der Längsausnehmung 20 im Sinne einer Rastung zusammenwirkt.

Unterhalb der lichtdurchlässigen Deckplatte 22 liegen als Leuchtsegmente die Enden der Lichtleiter 56. Diese Lichtleiter können in einer oder in mehreren Ebenen geführt sein. Alle Lichtleiter gehen von einem Leuchtzentrum aus, das im wesentlichen aus einem Fassungskörper 57 und einem im Hohlraum des Fassungskörpers drehbar gelagerten hülsenförmigen, lichtdurchlässigen Abdeckkörper 58 besteht. Im Zentrum des Abdeckkörpers ist eine Lichtquelle 59 angeordnet, die durch zwei Fassungen 60 auf beiden Seiten gehalten wird. Diese Fassungen aus Metall dienen gleichzeitig zur Spannungszuführung für die Lichtquelle wie auch für die Wärmeableitung. Um die Lichtquelle genau positionieren zu können, ist noch eine Halteplatte 61 vorhanden, die an der Führungsschiene befestigt ist. Eine der beiden Fassungen ist in einem Durchbruch der Halteplatte gehalten.

An einer Seite des Fassungskörpers 57 ist da, wo sich keine Lichtleiterlichtaustrittsstellen befinden, die Austrittsöffnung 62 für die beiden Farbbänder 63 ausgespart. Damit die Farbbänder definiert umgelenkt werden, ist eine Führung 64 vorhanden, die mit dem Fassungskörper verbunden ist.

In der in Figur 8 nicht sichtbaren Längsausnehmung der Führungsschiene 17 ist ein endloser Zahnriemen 18 geführt, der an beiden Seiten durch Umlenkrollen 19 umgelenkt wird. Außerdem ist der Zahnriemen 18 noch über eine Scheibe 65 geführt, die umfangseitig einen Zahnkranz aufweist. Wird der Schieber 16 bewegt, so dreht sich auch die Scheibe 65, die gleichzeitig Federträger z.B. für einen einstellbaren Widerstand oder einen Drehschalter ist. Der Zahnriemen selbst ist im Gleitkörper 21 zwischen den Spreizarmen 49 eingespannt. Der untere und der obere Anschlag für den Schieber wird durch die in die Längsausnehmungen hineinragenden Umlenkrollen 19 gebildet, an die die Spreizarme im Anschlag anstoßen.

Bei dem in den Figuren 8 bis 11 dargestellten Ausführungsbeispiel ist die Scheibe 65 gleichzeitig ein Federträger. Es wäre auch eine Lösung denkbar, bei der die Scheibe ein Zahnrad besitzt, das mit einer Zahnstange zusammenwirkt derart, daß beim Verstellen des Schiebers die Zahnstange verschoben wird. Mit dieser Zahnstange können z.B. Bowdenzüge bewegt werden.

Bezugszeichen zu 3/83
   1   Frontplatte
   2   Drehknopf
   3   Lichtleiter
   4   Leuchtsegmente
   5   Lichtquelle
   6   Fasungskörper
   7   Abdeckkörper
   8   Farbbänd
   9   Austrittsöffnung
  10   Führung
  11   Federträger
  12   Schleiffeder
  13   Widerstandsplatte
  14   Seilscheibe
  15   Einsatz
  16   Schieber
  17   Führungsschiene

| 18 | Zahnriemen |
|---|---|
| 19 | Umlenkrollen |
| 20 | Längsausnehmung |
| 21 | Gleitkörper |
| 22 | Deckplatte |
| 23 | Zahnstange |
| 24 | Lichtleiterlichteintrittsstelle |
| 25 | Vertiefung |
| 26 | Welle |
| 27 | Zahnrad |
| 28 | Sprengring |
| 29 | Baisteil |
| 30 | Griffstück |
| 31 | Rand |
| 32 | Vorsprung |
| 33 | Höhlung |
| 34 | Fenster |
| 35 | Schlitz |
| 36 | Nase |
| 37 | Einschnitt |
| 38 | Mulde |
| 39 | Führungsleiste |
| 40 | Zähne der Zahnstange |
| 41 | Durchbruch |
| 42 | Lampenfassung |
| 43 | Einbuchtung |
| 44 | Lichtleiter |
| 45 | Abdeckkörper |
| 46 | Fassungskörper |
| 47 | Schnapphaken |
| 48 | Aussparung |
| 49 | Spreizarme |
| 50 | Schieberarm |
| 51 | Federzunge |
| 52 | balliges Ende der Federzunge |
| 53 | Bremsfeder |
| 54 | Kammer |
| 55 | Auswölbung |
| 56 | Lichtleiter |
| 57 | Fassungskörper |
| 58 | Abdeckkörper |
| 59 | Lichtquelle |
| 60 | Fassung |
| 61 | Halteplatte |
| 62 | Austrittsöffnung |
| 63 | Farbband |
| 64 | Führung |
| 65 | Federträger |

## Patentansprüche

1. Leuchtbandanzeigeanordnung zur thermometerskalaähnlichen Anzeige der Stellung eines Betätigungsorganes mittels in einer Reihe angeordneter Leuchtsegmente, die von den Enden von Lichtleitern gebildet werden, die sternförmig zu einem zumindest teilweise aus einem lichtdurchlässigen Werkstoff hergestellten Leuchtzentrum hin geführt sind, wobei das Leuchtzentrum aus einem eine Lichtquelle aufnehmenden, zylindrischen Fassungskörper besteht, bei dem sich zwischen Lichtquelle und Lichtleiterlichteintrittsstelle ein das Licht verändernder und mit Hilfe des Betätigungsorganes relativ zum Fassungskörper drehbarer Abdeckkörper befindet, dadurch gekennzeichnet, daß am Abdeckkörper (7; 45) mindestens ein die Lichtleiterlichteintrittsstellen (24) abdeckendes Farbband (8; 63) befestigt und zwischen Abdeckkörper (7; 45) und Fassungskörper (6; 46) geführt ist, dessen Länge mindestens aller der am Umfang les Fassungskörpers vorgesehenen Lichtleiterlichteintrittsstellen (24) entspricht, wobei am Fassungskörper (6; 46) für das Farbband (8; 63) mindestens eine Austrittsöffnung (9; 62) mit einer Führung (10; 64) für das hervorstehende Farbband (8; 63) vorhanden ist.

2. Leuchtbandanzeigeanordnung nach Anspruch 1, dadurch gekennzeichnet, daß die Lichtleiterlichteintrittsstellen (24) nur auf einem Teil des Umfanges, vorzugsweise auf Dreiviertel des Umfanges, angeordnet sind.

3. Leuchtbandanzeigeanordnung nach Anspruch 1, dadurch gekennzeichnet, daß das Betätigungsorgan ein Drehknopf (2) ist, der mit dem eine Schleiffeder (12) tragenden Federträger (11) eines einstellbaren Widerstandes über Mitnahmemittel in Wirkverbindung steht.

4. Leuchtbandanzeigeanordnung nach Anspruch 1, dadurch gekennzeichnet, daß das Betätigungsorgan ein Drehknopf ist, der mit dem eine Schleiffeder tragenden Federträger eines Drehschalters über Mitnahmemittel in Wirkverbindung steht.

5. Leuchtbandanzeigeanordnung nach Anspruch 3 oder 4, dadurch gekennzeichnet, daß der Drehknopf (2) direkt mit dem Federträger (11) gekuppelt ist.

6. Leuchtbandanzeigeanordnung nach Anspruch 3 oder 4, dadurch gekennzeichnet, daß der Drehknopf (2) über eine Seilscheibe (14) und einen Seiltrieb mit dem Federträger verbunden ist.

7. Leuchtbandanzeigeanordnung nach Anspruch 5 oder 6, dadurch gekennzeichnet, daß der Federträger oder die Seilscheibe mit dem Abdeckkörper schlupffrei verbunden ist.

8. Leuchtbandanzeigeanordnung nach Anspruch 3 oder 4, dadurch gekennzeichnet, daß der Drehknopf (2) einen von der Lichtquelle angestrahlten, lichtdurchlässigen Einsatz (15) aufweist.

9. Leuchtbandanzeigeanordnung nach Anspruch 1, dadurch gekennzeichnet, daß die Lichtleiter (3; 56) in mehreren Ebenen angeordnet sind.

10. Leuchtbandanzeigeanordnung nach Anspruch 9, dadurch gekennzeichnet, daß die in mehreren Ebenen angeordneten Lichtleiter (3; 56) so geführt sind, daß die Leuchtsegmente (4) in einer Reihe liegen.

11. Leuchtbandanzeigeanordnung nach Anspruch 1, dadurch gekennzeichnet, daß das Betätigungsorgan ein in seiner Längsrichtung verschiebbarer Schieber (16) ist, der aus einer Führungsschiene (17) geführt ist.

12. Leuchtbandanzeigeanordnung nach Anspruch 11, dadurch gekennzeichnet, daß der Schieber (16) Teil eines einstellbaren Widerstandes oder eines Schalters ist.

13. Leuchtbandanzeigeanordnung nach Anspruch 11, dadurch gekennzeichnet, daß der Schieber (16) durch ein als Zahnriemen (18) ausgebildetes endloses Band über Umlenkrollen (19) mit einem als Scheibe ausgebildeten Federträger (65) verbunden ist.

14. Leuchtbandanzeigeanordnung nach Anspruch 11, dadurch gekennzeichnet daß die Führungsschiene (17) beidseitig in den Seitenwandungen zwei Längsausnehmungen (20) aufweist, in denen stegartige Gleitkörper (21) des Schiebers (16) geführt sind.

15. Leuchtbandanzeigeanordnung nach Anspruch 11 und 13, dadurch gekennzeichnet, daß die Umlenkrollen (19) gleichzeitig die Anschläge für den Schieber (16) sind.

16. Leuchtbandanzeigeanordnung nach einem der Ansprüche 11 bis 15, dadurch gekennzeichnet, daß die Führungsschiene (17) eine lichtdurchlässige, sich in Schieberichtung erstreckende, längliche Deckplatte (22) besitzt, die die in der Führungsschiene (17) gehalterten Leuchtsegmente (4) abdeckt.

17. Leuchtbandanzeigeanordnung nach Anspruch 16, dadurch gekennzeichnet, daß die Deckplatte (22) in einer stirnseitigen Vertiefung (25) der Führungsschiene (17) eingesetzt ist und mit deren Oberfläche etwa plan verläuft.

18. Leuchtbandanzeigeanordnung nach Anspruch 11, dadurch gekennzeichnet, daß mit dem Schieber ein Bremsorgan zusammenwirkt.

19. Leuchtbandanzeigeanordnung nach Anspruch 18, dadurch gekennzeichnet, daß das Bremsorgan gleichzeitig Rastorgan für den Schieber (16) ist.

20. Leuchtbandanzeigeanordnung nach Anspruch 18, dadurch gekennzeichnet, daß der Schieber (16) das Bremsorgan trägt.

21. Leuchtbandanzeigeanordnung nach Anspruch 20, dadurch gekennzeichnet, daß das Bremsorgan mindestens eine angeformte Federzunge (51) ist, die dem Bremsen und/oder dem Rasten dient.

22. Leuchtbandanzeigeanordnung nach Anspruch 20, dadurch gekennzeichnet, daß das Bremsorgan eine in den Schieber eingesetzte Bremsfeder (53) ist, die dem Bremsen und/oder Rasten dient.

23. Leuchtbandanzeigeanordnung nach Anspruch 1, dadurch gekennzeichnet, daß das Betätigungsorgan (2, 16) mit einer geführten Zahnstange (23) in Wirkverbindung steht, die mittelbar oder unmittelbar auf ein Verstellglied einwirkt.

**Revendications**

1. Dispositif d'affichage à bande lumineuse, destiné à un affichage, analogue à l'échelle thermométrique, de la position d'un organe d'actionnement au moyen de segments lumineux disposés de manière à constituer une rangée et qui sont formés par les extrémités de conducteurs de lumière qui passent en étoile jusqu'à un ensemble lumineux central fabriqué au moins partiellement en un matériau transparent, l'ensemble lumineux central étant constitué par un corps de monture cylindrique qui loge une source lumineuse, dans lequel se trouve un corps de recouvrement modifiant la lumière entre la source lumineuse et le point d'entrée de la lumière dans les conducteurs de lumière, et qui est susceptible d'être tourné, par rapport au corps de monture, à l'aide de l'organe d'actionnement, dispositif caractérisé en ce qu'au moins une bande de couleur (8, 63) recouvrant les points (24) d'entrée des conducteurs de lumière, est fixée sur le corps (7; 45) de recouvrement et en ce qu'elle passe entre le corps (7; 45) de recouvrement et le corps (6; 46) de monture, sa longueur correspondant au moins à tous les points (24) d'entrée de lumière dans les conducteurs de lumière prévus sur le pourtour du corps de monture, au moins une ouverture (9, 62) de sortie, comportant un élément (10, 64) de guidage, étant prévue pour la bande de couleur (8, 63) qui dépasse.

2. Dispositif d'affichage à bande lumineuse selon la revendication 1, caractérisé en ce que les points (24) d'entrée de lumière dans les conducteurs de lumière ne sont disposés que sur une partie du pourtour, de préférence sur les trois-quarts du pourtour.

3. Dispositif d'affichage à bande lumineuse selon la revendication 1, caractérisé en ce que l'organe d'actionnement est un bouton tournant (2), qui est relié fonctionnellement par l'intermédiaire de moyens d'entraînement au support de ressort portant un ressort ou patin frotteur et appartenant à un potentiomètre.

4. Dispositif d'affichage à bande lumineuse selon la revendication 1, caractérisé en ce que l'organe d'actionnement est un bouton tournant, qui est relié fonctionnellement par l'intermédiaire de moyens d'entraînement à un support de ressort portant un ressort frotteur, appartenant à un interrupteur tournant.

5. Dispositif d'affichage à bande lumineuse selon la revendication 3 ou 4, caractérisé en ce que le bouton tournant (2) est accouplé directement au support (11) de ressort.

6. Dispositif d'affichage à bande lumineuse selon la revendication 3 ou 4, caractérisé en ce que le bouton tournant (2) est relié, par une poulie (14) pour câble et par une câblerie, au support de ressort.

7. Dispositif d'affichage à bande lumineuse selon la revendication 5 ou 6, caractérisé en ce que le support de ressort ou la poulie pour câble sont reliés sans glissement au corps de recouvrement.

8. Dispositif d'affichage à bande lumineuse selon la revendication 3 ou 4, caractérisé en ce que le bouton tournant (2) présente une pièce rapportée (15) transparente soumise au rayonnement de la source lumineuse.

9. Dispositif d'affichage à bande lumineuse selon la revendication 1, caractérisé en ce que les conducteurs (3, 56) de lumière sont disposés sur plusieurs plans.

10. Dispositif d'affichage à bande lumineuse selon la revendication 9, caractérisé en ce que les conducteurs (3, 56) de lumière disposés sur plusieurs plans, sont placés de façon telle que les segments lumineux (4) sont disposés de manière à constituer une série ou une rangée.

11. Dispositif d'affichage à bande lumineuse selon la revendication 1, caractérisé en ce que l'organe d'actionnement est un curseur (16) susceptible de se déplacer dans le sens de sa longueur, et qui est guidé sur un rail (17) de guidage.

12. Dispositif d'affichage à bande lumineuse selon la revendication 11, caractérisé en ce que le curseur (16) fait partie d'un potentiomètre ou d'un interrupteur.

13. Dispositif d'affichage à bande lumineuse selon la revendication 11, caractérisé en ce que le curseur (16) est relié par une bande sans fin, conformée en courroie dentée (18) passant sur des rouleaux (19) de renvoi, à un support (65) de ressort conformé en poulie.

14. Dispositif d'affichage à bande lumineuse selon la revendication 1, caractérisé en ce que le rail (17) de guidage présente des deux côtés dans les parois latérales des évidements longitudinaux (20), dans lesquels sont guidés des corps coulissants (21), en forme de barrettes, du curseur (16).

15. Dispositif d'affichage à bande lumineuse selon les revendications 11 et 13, caractérisé en ce que les rouleaux (19) de renvoi constituent en même temps des butées pour le curseur (16).

16. Dispositif d'affichage à bande lumineuse selon les revendications 11 à 15, caractérisé en ce que le rail (17) de guidage est doté d'une plaque (22) de recouvrement oblongue transparente, qui s'étend dans le sens du coulissement et que recouvre les segments lumineux (4) fixés dans le rail (17) de guidage.

17. Dispositif d'affichage à bande lumineuse selon la revendication 16, caractérisé en ce que la plaque (22) de recouvrement est placée dans un creux (25) ménagé du côté avant du rail (17) de guidage et en ce qu'elle s'étend en affleurement avec la surface de celui-ci.

18. Dispositif d'affichage à bande lumineuse selon la revendication 11, caractérisé en ce qu'un organe de freinage agit en conjugaison avec le curseur.

19. Dispositif d'affichage à bande lumineuse selon la revendication 18, caractérisé en ce que l'organe de freinage constitue en même temps un organe d'encliquetage pour le curseur (16).

20. Dispositif d'affichage à bande lumineuse selon la revendication 18, caractérisé en ce que le curseur (16) porte l'organe de freinage.

21. Dispositif d'affichage à bande lumineuse selon la revendication 20, caractérisé en ce que l'organe de freinage est constitué par au moins une languette à ressort (51) formée sur le curseur et que sert au freinage et/ou à l'encliquetage.

22. Dispositif d'affichage à bande lumineuse selon la revendication 20 caractérisé en ce que l'organe de freinage est un ressort (53) de freinage monté dans le curseur, et qui sert au freinage et/ou à l'encliquetage.

23. Dispositif d'affichage à bande lumineuse selon la revendication 1, caractérisé en ce que l'organe (2, 16) d'actionnement est relié fonctionnellement à une crémaillère (23) guidée, qui agit directement ou indirectement sur un organe de réglage.

**Claims**

1. Light strip display arrangement for displaying in a way similar to a thermometer scale the position of an actuating element by means of luminous segments arranged in a row and formed by the ends of light guides guided in the shape of a star towards a light centre which is made at least partially from a light-permeable material, the light centre consisting of a cylindrical holder body accommodating a light source, wherein there is located between the light source and the light guide light entry point a cover body which varies the light and by means of the actuating element is capable of rotating relative to the holder body, characterised in that at least one colour strip (8; 63) covering the light guide light entry points (24) is secured to the cover body (7; 45) and is guided between the cover body (7; 45) and the holder body (6; 46), the length of which corresponds at least to all the light guide light entry points (24) provided on the periphery of the holder body, wherein there is present on the holder body (6; 46) for the colour strip (8; 63) at least one exit opening (9; 62) with a guide (10; 64) for the protruding colour strip (8; 63).

2. Light strip display arrangement according to claim 1, characterised in that the light guide light entry points (24) are only arranged on part of the periphery, preferably threequarters of the periphery.

3. Light strip display arrangement according to claim 1, characterised in that the actuating element is a rotary button (2) which is in operative connection via driving means with the spring support (11) of an adjustable resistance which supports a brush spring (12).

4. Light strip display arrangement according to claim 1, characterised in that the actuating element is a rotary button which is in operative connection via driving means with the spring support of a rotary switch which supports a brush spring.

5. Light strip display arrangement according to claim 3 or 4, characterised in that the rotary button (2) is coupled directly with the spring support (11).

6. Light strip display arrangement according to claim 3 or 4, characterised in that the rotary button (2) is connnected via a pulley (14) and a cable drive to the spring support.

7. Light strip display arrangement according to claim 5 or 6, characterised in that the spring support or the pulley is connected in a non-slip manner to the cover body.

8. Light strip display arrangement according to claim 3 or 4, characterised in that the rotary button (2) has a light-permeable insert (15) illuminated by the light source.

9. Light strip display arrangement according to claim 1, characterised in that the light guides (3; 56) are arranged in several planes.

10. Light strip display arrangement according to claim 9, characterised in that the light guides (3; 56) arranged in several planes are guided such that the luminous segments (4) lie in a row.

11. Light strip display arrangement according to claim 1, characterised in that the actuating element is a slide (16) displaceable in its longitudinal direction and guided on a guide rail (17).

12. Light strip display arrangement according to claim 11, characterised in that the slide (16) is part of an adjustable resistance or of a switch.

13. Light strip display arrangement according to claim 11, characterised in that the slide (16) is connected by a continuous band designed as a toothed belt (18) via deflection rollers (19) to a spring support (65) designed as a disc.

14. Light strip display arrangement according to claim 11, characterised in that the guide rail (17) has on both sides in its side walls two longitudinal recesses (20) in which bar-like slide bodies (21) of the slide (16) are guided.

15. Light strip display arrangement according to claims 11 and 13, characterised in that the deflection rollers (19) are simultaneously the stops for the slide (16).

16. Light strip display arrangement according to one of claims 11 to 15, characterised in that the guide rail (17) has a light-permeable oblong cover plate (22) extending in the sliding direction and covering the luminous segments (4) mounted in the guide rail (17).

17. Light strip display arrangement according to claim 16, characterized in that the cover plate (22) is inserted in an indentation (25) on the front side of the guide rail (17) and runs approximately level with its surface.

18. Light strip display arrangement according to claim 11, characterised in that a braking element cooperates with the slide.

19. Light strip display arrangement according to claim 18, characterised in that the braking element is at the same time a locking element for the slide (16).

20. Light strip display arrangement according to claim 18, characterised in that the slide (16) carries the braking element.

21. Light strip display arrangement according to claim 20, characterised in that the braking element is at least one moulded-on flexible tongue (51) which serves to brake and/or to lock.

22. Light strip display arrangement according to claim 20, characterised in that the braking element is a brake spring (53) inserted in the slide and serving to brake and/or to lock.

23. Light strip display arrangement according to claim 1, characterised in that the actuating element (2, 16) is in operative connection with a guided toothed rack (23) which acts indirectly or directly on an adjustment element.

**Fig. 1**

Fig: 2

Fig. 3

Fig. 4

Fig: 5

Fig: 6

**Fig: 7**

Fig: 8

**Fig: 9**

18

65

57

63

60

59

58

61

63

18

56

17

49

19

50

22

16

**Fig: 10**

49
21
53
50
55
54
21
49

Fig. 11